# EUROPÄISCHE PATENTANMELDUNG

(11) **EP 1 278 073 A1**
(43) Veröffentlichungstag der Anmeldung: **22.01.2003**
(21) Anmeldenummer: 02016020.6
(22) Anmeldetag: 18.07.2002
(51) Int. Cl.: G01R 35/04, G01R 21/133, G01R 19/252

(54) **Einrichtung zur Messung des fliessenden elektrischen Stromes in mindestens einem elektrischen Leiter und Verfahren zur Fehlerkorrektur von solchen Einrichtungen**

(30) Priorität: 20.07.2001 DE 10136940; 20.07.2001 DE 20112485 U
(71) Anmelder: ENSECO GmbH, 81379 München (DE)
(72) Erfinder: Meyer, Gerhard, Dr.-Ing., 16356 Eiche (DE)
(74) Vertreter: Jacoby, Georg

(57) **Zusammenfassung**

Die Erfindung betrifft Einrichtungen zur Messung des fließenden elektrischen Stromes in mindestens einem elektrischen Leiter, der mit wenigstens einem elektrischen Verbraucher verbunden ist, und Verfahren zur Fehlerkorrektur von Einrichtungen zur Messung des fließenden elektrischen Stromes in mindestens einem elektrischen Leiter, der mit wenigstens einem elektrischen Verbraucher verbunden ist, und wobei die Messwerte in eine dem Messwert äquivalente elektrische Impulsfolge gewandelt werden.

Diese zeichnen sich besonders durch die Möglichkeiten einer numerischen Fehlerkorrektur und Kalibrierung aus. Das basiert auf einer softwaregesteuerten und die Fehlerkorrektur und die Kalibrierung übernehmenden Steuer- und Verarbeitungseinheit.

Die Fehlerkorrektur der Einrichtungen erfolgt gegenüber einen Referenzzähler oder einen Kalibrator, wobei innerhalb eines festgelegten Zeitintervalls die Ausgangsimpulsfolge der Einrichtung hinsichtlich ihrer Impulszahl in geeignet kleinen Iterationsschritten jeweils soviel Impulse der Eingangsimpulsfolge abgezogen oder hinzugefügt werden, dass eine nominelle Impulszahl gleich groß ist, obwohl ihr analoges Bearbeitungsfenster unterschiedlich war.

## Beschreibung

Die Erfindung betrifft Einrichtungen zur Messung des fließenden elektrischen Stromes in mindestens einem elektrischen Leiter, der mit wenigstens einem elektrischen Verbraucher verbunden ist, und Verfahren zur Fehlerkorrektur von Einrichtungen zur Messung des fließenden elektrischen Stromes in mindestens einem elektrischen Leiter, der mit wenigstens einem elektrischen Verbraucher verbunden ist, und wobei die Messwerte in eine dem Messwert äquivalente elektrische Impulsfolge gewandelt werden.

Stromzähler sind unter anderem als Ferrariszähler bekannt. Dabei läuft eine drehbar gelagerte Ankerscheibe aus Aluminium zwischen den Polen zweier Elektromagnete hindurch, von denen einer die Stromspule und der andere die Spannungsspule trägt. Die Felder dieser Magneten bilden ein Wanderfeld aus, so dass die Ankerscheibe in Drehbewegung gesetzt wird. Ein Dauermagnet ruft ein Bremsmoment hervor. Die Umdrehungen der Scheibe sind der elektrischen Arbeit proportional und werden durch ein Zählwerk summierend angezeigt. Der Nachteil liegt in der bewegten Ankerscheibe, so dass ein lageunabhängiger Einbau wegen der sich vergrößernden Reibung in den Lagern auf die Messgenauigkeit auswirkt und die Benutzung des Zählers nicht mehr möglich ist. Die Eichung kann erst nach Erreichen des dynamischen Betriebs erfolgen. Eine Manipulierbarkeit des Zählers ist nicht ausgeschlossen.
Eine erste Gruppe von Lösungen, die diese Nachteile vermeiden, sind einfach aufgebaute und nichteichfähige elektronische Energiezähler. Diese Stromkostenzähler dienen einer groben Erfassung des Verbrauchs an elektrischer Energie, z.B. der annähernden Messung des elektrischen Energieverbrauches eines Gerätes im Haushalt.
Eine derartige Lösung ist unter anderem in der DE OS 36 19 053 A1 (Stromkostenzähler) aufgeführt. Bei dieser Lösung erfolgt nur die Erfassung des Stromverbrauches über einen in die Zuleitung geschalteten Messwiderstand. Die stromäquivalente Spannung wird verstärkt, in eine äquivalente Frequenz umgesetzt und über einen Zähler einer Anzeige zugeführt. Mit dieser Lösung kann die verbrauchte Energie nur annähernd bestimmt werden.
Eine ähnliche Lösung ist in der DE OS 37 43 034 A1 (Elektrisches und/oder elektronisches Installationsgerät) zu finden. Hauptaugenmerk der beschriebenen Lösung gilt den einsatzfähigen Gehäusemöglichkeiten und nicht der Auswerteschaltung.
Eine zweite Gruppe elektronischer Energiezähler zeichnen sich durch ihre Eichfähigkeit aus. Ein derartiger Energiezähler ist unter anderem durch die DE OS 196 06 927.0 A1 (Elektronische Energiezähler) bekannt. Dabei werden ein stromäquivalenter Spannungswert, der an einem in die Phase geschalteten Widerstand anliegt, und die am Verbraucher anliegende Spannung gleichzeitig über zwei Analog-Digital-Umsetzer in jeweils ein digitales Signal umgesetzt. Über einen digitalen Multiplizierer und einen nachgeschalteten Leistungs-Frequenz-Wandler entsteht eine Impulsfolge, die dem Produkt der Spannungen äquivalent ist. Mit einer extern einstellbaren Referenzspannung ist die Eichfähigkeit dieser Messschaltung gegeben. Diese Impulsfolge wird unter anderem auf einen elektronischen Zähler geschalten, der mit einem Rollenzähler verkoppelt ist. Damit ist eine ständige Ablesbarkeit der verbrauchten Leistung gegeben. Die Referenzspannung muss für jeden Energiezähler separat eingestellt werden, so dass eine automatische Herstellung weitestgehend nicht möglich ist.
Hauptaugenmerk der DE OS 198 42 241 A1 (Elektrizitätszähler und Eingangsbaustein für einen Elektrizitätszähler) gilt einem hoch integrierten Eingangsbaustein, der universell für verschiedenste Anwendungen eingesetzt werden kann. Damit ist es möglich, für eine nachfolgende Signalverarbeitung standardmäßige Prozessoren oder digitale Signalprozessoren einzusetzen. Diese Prozessoren beinhalten Speicher, in denen Parameter und/oder Betriebseinstellungen und/oder sonstige für den Betrieb vorgeb- oder einstellbare Daten gespeichert oder speicherbar sind. Auf eine Wirkungsweise insbesondere der Daten der Parameter und/oder Betriebseinstellungen wird nicht näher eingegangen.
In der DE PS 197 13 120 C1 (Elektrizitätszähler) ist ein Elektrizitätszähler für Mehrphasennetze aufgeführt. Dabei werden die Spannungs- und Stromsignale über jeweils einen Signalkanal einer digitalen Signalverarbeitungseinrichtung zugeführt. Jeder der beiden Signalkanäle weist einen Multiplexer mit einem nachgeschalteten Analog- Digital- Wandler auf. Die Multiplexer dienen dem Zuschalten der zusammengehörigen Strom- und Spannungswerte der jeweiligen Phase, so dass ein einfacher Aufbau eines Mehrphasenzählers vorhanden ist. Auf eine Kalibrierung wird nicht näher eingegangen.

Der in den Patentansprüchen 1 und 8 angegebenen Erfindung liegt das Problem zugrunde, fehlerkorrigierte und kalibrierte Einrichtungen zur Messung des fließenden elektrischen Stromes und Verfahren zur Kalibrierung und Fehlerkorrektur von solchen Einrichtungen zu schaffen.

Dieses Problem wird mit den in den Patentansprüchen 1 und 8 aufgeführten Merkmalen gelöst.

Die Einrichtungen zur Messung des fließenden elektrischen Stromes in mindestens einem elektrischen Leiter zeichnen sich besonders durch die Möglichkeiten einer numerischen Fehlerkorrektur und Kalibrierung aus. Das basiert auf einer softwaregesteuerten und die Fehlerkorrektur und die Kalibrierung übernehmenden Verarbeitungseinheit. Dadurch ist es weiterhin möglich, die Fehler der die Leistung in den Leitern/Phasen messenden Anordnungen jeweils unabhängig von weiteren Anordnungen innerhalb des elektronischen Energiezählers zu kompensieren.
Die Fehlerkorrektur der Einrichtungen erfolgt gegenüber einen Referenzzähler oder einen Kalibrator, der die am Prüfpunkt typischen Strom- und Spannungswerte mit geeignet hoher Genauigkeit darstellt und als Normalspannung/ -strom für den Prüfling oder die Prüflinge bereitstellt, wobei innerhalb eines festgelegten Zeitintervalls die Ausgangsimpulsfolge der Einrichtung hinsichtlich ihrer Impulszahl in geeignet kleinen Iterationsschritten jeweils soviel Impulse der Eingangsimpulsfolge abgezogen oder hinzugefügt werden, dass eine nominelle Impulszahl gleich groß ist, obwohl ihr analoges Bearbeitungsfenster unterschiedlich war. Die Korrektur basiert dabei auf einer Korrektursoftware, die im Prüfsystem implementiert ist und vorher durch eine Programmierung eines Speichermoduls in den Einrichtungen vorliegt. Der Fehlerkorrekturwert liegt tabellarisch im Prüfsystem vor.
Dabei wird weder eine Verstellung noch eine andere mechanische oder elektrische Manipulation sondern nur ein innerer Softwarezuordnungsalgorithmus vorgenommen, der zu einer numerischen Korrektur der messwertbestimmenden Impulsfolge führt.
In die Speichereinheit der Verarbeitungseinheit können auch weitere Daten eingeschrieben werden, die die Einrichtungen näher bestimmen und den aktuellen Stromfluss zuordnen, z.B. entsprechend verschiedener Tarife oder Lieferverträge von unterschiedlichen Anbietern.
Alle wichtigen Daten befinden sich in einem nichtflüchtigen Speicher der Speichereinheit, so dass bei einem Stromausfall die Daten nicht verloren gehen.
Die Einrichtungen zeichnen sich weiterhin dadurch aus, dass die Abnahme elektrischer Energie messtechnisch erfasst und lokal angezeigt wird. Die Zuordnung von Kosten zu Einzelverbrauchern, Anlagensystemen und Maschinen sind spezifisch abrechenbar. Gleichzeitig ist damit ein Instrument für eine individuelle Beurteilung der einzelnen Verbraucher gegeben. Damit ist insbesondere in Gewerbe- und Büroeinrichtungen die nutzerspezifische Zuordnung der Energiekosten möglich. Eine detaillierte und zuordenbare Kostenerfassung ist bei der Maschinenverschleißermittlung, in Messarealen, in Freizeit- und Hotelbereichen, in elektrischen Energietankstellen für Land- und Wasserfahrzeuge, in Marktbereichen und in Campinganlagen möglich.
Die Einrichtungen verfügen weiterhin über wenigstens eine Schnittstelle, mit der unter anderem bidirektional Messdaten, Gerätenummern, Spitzenverbrauch, Tarife und Kosten übertragbar sind.
Die Einrichtungen zeichnen ich weiterhin durch ihren lageunabhängigen Betrieb aus.
Ein weiterer Vorteil besteht darin, dass diese auch so ausgestaltbar sind, dass über galvanisch von der Messelektronik getrennte Ein- und Ausgänge eine externe Ablesbarkeit möglich ist.

Die Verfahren zur Fehlerkorrektur von Einrichtungen zur Messung des fließenden elektrischen Stromes in mindestens einem elektrischen Leiter, der mit wenigstens einem elektrischen Verbraucher verbunden ist, und wobei die Messwerte in eine dem Messwert äquivalente elektrische Impulsfolge gewandelt werden, zeichnen sich vor allem dadurch aus, dass ein ihn zugrundeliegender Messfehler korrigierbar ist. Dabei wird die Abweichung entsprechend einer Referenzeinrichtung oder über einen Kalibrator, der die am Prüfpunkt typischen Strom- und Spannungswerte mit geeignet hoher Genauigkeit darstellt und als Normalspannung/ -strom für den Prüfling oder die Prüflinge bereitstellt, festgestellt und ein darauf basierender Fehlerkorrekturwert aus dem Prüfsystem in die Einrichtungen fehlerbezogen implementiert. Diese bewirken in den Einrichtungen, dass von der die Impulsfolge auslösenden fehlerhaften Messung eine optimal korrigierte Impulsfolge entsteht, die die Proportionalitätsforderung zur der die Einrichtungen durchfließenden elektrischen Arbeit gewährleistet.

Vorteilhafte Ausgestaltungen der Erfindung sind in den Patentansprüchen 2 bis 7, 9 und 10 angegeben.

Die Weiterbildungen der Patentansprüche 2 und 9, wobei die Anordnung mit dem mindestens einen elektrischen Leiter und einem Bezugspotential so zusammengeschaltet ist, dass eine Anordnung vorhanden ist,
- die neben dem elektrischen Strom gleichzeitig die Messung der anliegenden elektrischen Spannung ermöglicht und
- die weiterhin eine die Messwerte des fließenden elektrischen Stromes und der dazu anliegenden elektrischen Spannungen in äquivalente elektrische Impulsfolgen der Leistung wandelt.
Mit dem niederohmigen Messwiderstand, der Anordnung, der Verarbeitungseinheit und der Stromversorgungseinheit ist vorteilhafterweise ein elektronischer Energiezähler gegeben.

Die Einrichtung zeichnet sich durch die Weiterbildung des Patentanspruchs 3 weiterhin dadurch aus, dass auch Messbereiche mit unterschiedlichen Fehlern über die Steuer- und Verarbeitungseinheit spezifisch korrigierbar sind, wobei der jeweils aktuelle Messwert dem dazugehörigem Fehlerkorrekturwert zugeordnet wird und daraufhin dieser Messwert mit dem Fehlerkorrekturwert korrigiert wird.

Eine Fehlerkorrektur der Einrichtung erfolgt nach der Weiterbildung des Patentanspruchs 4 durch das Unterdrücken oder Ergänzen von Impulsen entsprechend des Messfehlers in Messintervallen oder auch quasi stetig. Die Anzahl der Impulse ist dem Fehlerkorrekturwert des elektronischen Energiezählers in einem Speicher zugeordnet. In jedem Messintervall, in dem Strom und Spannung gleichzeitig gemessen wird, wird einem diesem Zeitbereich zugeordneter Energiewert dargestellt. Damit ist eine einfache Möglichkeit einer Korrektur gegeben.

Eine Verteilung der zu unterdrückenden Impulse über den gesamten Bereich des Messintervalls nach den Weiterbildungen der Patentansprüche 5 und 10 führt zu einer Verkürzung des Zeitraums bei der Fehlerkorrektur. Für einen sehr kurzen Zeitabschnitt und kleinen Fehlerstrom würde man ansonsten einen unkorrigierten Wert erhalten. Gleichzeitig sinkt die Zeit für die Kalibrierung des elektronischen Energiezählers während der Inbetriebnahme und Kalibrierung. Die Kalibrierzeit wird wesentlich gesenkt und damit die Verweildauer der Messanlage mit hoher Abschreibungsrate, so dass sich schließlich die Kosten der Einrichtung erhöhen.

Die Anordnung aus den Analog-Digital-Umsetzern, dem digitalen Multiplizierer und dem Leistungs-Frequenz-Wandler nach der Weiterbildung des Patentanspruchs 6 liefert eine dem aktuellen Leistungswert äquivalente weiterverarbeitbare Impulsfolge. Dieses Messsystem ist voll elektronisch ausgeführt und damit lageunabhängig betreibbar und unabhängig weiterer Störgrößen wie z.B. Magnetfelder ausgeführt.

Mit mehreren der Zahl der elektrischen Leiter zu wenigstens einem Verbraucher entsprechenden niederohmigen Messwiderständen, wobei jeweils ein niederohmiger Messwiderstand mit einer Anordnung verbunden und die Anordnungen mit einer Verarbeitungseinheit zusammengeschaltet sind, nach der Weiterbildung des Patentanspruchs 7 ist ein fehlerkorrigierter und kalibrierbarer elektronischer Energiezähler für Mehrphasennetze vorhanden.

Ausführungsbeispiele der Erfindung sind in den Zeichnungen dargestellt und werden im folgenden näher beschrieben.
Es zeigen:
- Fig. 1: ein Blockschaltbild einer Einrichtung als elektronischer Energiezähler für Einphasennetze und
- Fig. 2: ein Blockschaltbild einer Einrichtung als elektronischer Energiezähler für Dreiphasennetze.
In den folgenden Ausführungsbeispielen werden sowohl Einrichtungen als elektronische Energiezähler für Ein- und Mehrphasennetze als auch Verfahren zur Kalibrierung und Fehlerkorrektur zusammen näher erläutert.

### 1. Ausführungsbeispiel

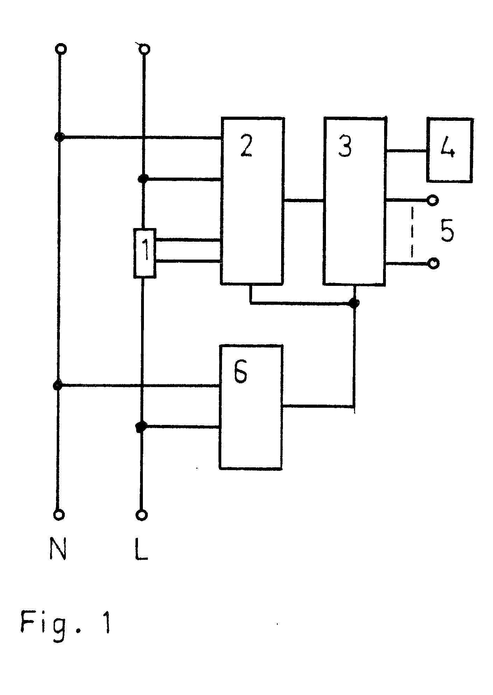

Eine Einrichtung als elektronischer Energiezähler für Einphasennetze besteht in einem ersten Ausführungsbeispiel aus den Grundbestandteilen
- einer Anordnung 2 mit einem mit dem Leiter/der Phase L und dem Nullleiter N verbundenen ersten Analog-Digital-Umsetzer, einem mit zwei Abgriffen zur Abnahme des stromäquivalenten Spannungsabfalls eines im Stromleiter geschalteten niederohmigen Messwiderstands 1, wobei an den Abgriffen eine stromproportionale Spannung anliegt, verbundenen zweiten Analog-Digital-Umsetzers oder auch einer Stromwandlerschaltung, deren Ausgangsspannung proportional des fließenden Stromes ist, einem den Analog-Digital-Umsetzern nachgeschalteten digitalen Multiplizierer oder einen anderen Schaltungsanordnung, bei der die Ausgangsspannung des ersten Analog-Digital-Umsetzers die Referenzspannung des zweiten Analog-Digital-Umsetzers bildet und sonst die Multiplikation der beiden Messfaktoren durchführt und einem Leistungs-Frequenz-Wandler,
- einer Steuer- und Verarbeitungseinrichtung 3, vorzugsweise ein Mikrorechner, ein Mikrocontroller, eine programmierbare Logiken, mit mindestens einem Speicher, der die Steuerfunktion des elektronischen Energiezählers mit übernehmen kann oder auch durch eine weitere Steuer- und Verarbeitungseinrichtung als z.B. weiterer Mikrorechner realisiert wird,
- einer Anzeigeeinheit 4,
- mindestens einer Schnittstelle 5 und
- einer Stromversorgungseinheit 6.
Die Anordnung zur Messung der aktuellen Spannung und des zeitgleich dazugehörigen fließenden elektrischen Stromes, der Multiplikation und der Leistungs-Frequenz-Wandlung ist bekannt. Die Analog-Digital-Umsetzer, der Multiplizierer und der Leistungs-Frequenz-Wandler sind dabei im wesentlichen Bestandteile eines elektronischen Bauelements in Form eines elektronischen Schaltkreises auf dessen Chip die wesentlichen Funktionen untergebracht sind. In der Fig. 1 sind dementsprechend diese Bestandteile als eine Anordnung 2 dargestellt.
Der Ausgang der Anordnung 2 ist mit der Steuer- und Verabeitungseinrichtung 3 verbunden. Dabei handelt es sich vorteilhafterweise um einen 8-Bit-Mikrorechner mit einem RISC-Mikroprozessor in CMOS-Technologie, einem nichtflüchtigen Speicher in Form eines EEPROMs zur Datensicherung, einem flüchtigen Speicher in Form eines RAMs als Arbeitsspeicher und mehreren Ein-/Ausgängen, wobei mehrere interruptfähige Eingänge sind.
Die Anordnung 2 für die auch auf unterschiedlichen Potenzialbezug arbeitende Messwerke besitzt einen Fehler von z.B. ± 10%. Die Impulsfrequenz entspricht einem Wert von z.B. 900.000 Impulsen/kWh abgegebener Leistung. Die Steuer- und Verabeitungseinrichtung 3 dient der Fehlerkorrektur und der Kalibrierung des jeweils aktuellen Messwerts sowie der Steuerung des Gesamtsystems.
Die Steuer- und Verarbeitungseinrichtung 3 erfasst alle Impulse. Je nach Anfangsfehler werden in der ersten Verarbeitungsstufe alle die Impulse für die weitere Verarbeitung unterdrückt oder hinzugefügt, die in Bezug auf die genannten 900.000 Impulse/kWh zu viel oder zu wenig sind. Es wird ein Zeitbereich der Messwertverarbeitung in der Steuer- und Verarbeitungseinrichtung 3 festgelegt, in dem mittels eines Korrekturfaktors, der bei jedem Energiezähler entsprechend des Anfangsfehlers verschieden sein kann, der erzeugten Impulszahl Impulse entsprechend des Korrekturfaktors proportional hinzufügt oder unterdrückt. Nach dieser Bearbeitung entsteht somit bei allen Energiezählern für den jeweils gleichen Messpunkt eine Impulszahl, die innerhalb für die Kalibrierung zulässigen Fehlergrenze liegt. Die zu unterdrückenden oder die zu ergänzenden Impulse werden über n Intervalle innerhalb der Messzeit weitgehend gleichverteilt. Ansonsten würde man für einen sehr kurzen Zeitabschnitt und kleinen Fehlerstrom einen unkorrigierten Wert erhalten. Die zu unterdrückenden oder hinzuzufügenden Impulse sind in den n-1 Intervallen gleichverteilt. Der Rest der zu unterdrückenden oder hinzuzufügenden Impulse wird im letzten Intervall entsprechend unterdrückt oder ergänzt.
Die jeweilige Anzahl der zu unterdrückenden oder hinzuzufügenden Impulse je Intervall werden durch Vergleich mit einem Normalzähler oder einem Kalibrator, der die am Prüfpunkt typischen Strom- und Spannungswerte mit geeignet hoher Genauigkeit darstellt und als Normalspannung/ -strom für den Prüfling oder die Prüflinge bereitstellt, ermittelt. Danach erfolgt eine Speicherung der abzuziehenden oder hinzuzufügenden Zahl der Impulse und/oder deren Verteilung über die n Intervalle in den mit der Steuer- und Verabeitungseinrichtung 3 verbundenem nichtflüchtigen Speichers insbesondere als EEPROM. Während des Einsatzes des elektronischen Energiezählers wird der aktuelle fehlerhafte Messwert mit dem Fehlerkorrekturwert in entsprechenden Intervallen zyklisch korrigiert.
Die Steuer- und verarbeitungseinrichtung 3 dient weiterhin für folgende Funktionen:
- Ansteuerung einer Anzeige 3 in Form z.B. eines Zählwerkes oder einer elektronischen Ziffernanzeige,
- Ansteuerung wenigstens einer Schnittstelle 5, insbesondere eine galvanisch getrennte S0-Schnittstelle als Datenquelle für Energiemanagementsysteme oder anderer Systeme,
- in einer Ausführungsform Ansteuerung wenigstens eines optischen Ausgangs in Form z.B. einer Lumineszenzdiode für Prüfzwecke, zur Sichtanzeige der Funktion des Energiezählers und/oder für eine Grobeinschätzung des Energieflusses,
- in einer weiteren Ausführungsform Ansteuerung einer Betriebsanzeige in Form z.B. einer weiteren Lumineszenzdiode, die den normalen Arbeitsbereich des Energiezählers anzeigt.
In einer weiteren Ausführungsform können auch mehrere Anzeigeeinheiten 4 alternativ angesteuert werden, so dass der elektronische Energiezähler auch als Mehrtarifzähler mit Parallelanzeige oder auch sequentieller Anzeige für mehrere Tarife realisierbar ist.
Voreingestellt ist immer die Ansteuerung des Ausgangs für einen Tarif. Eine Tarifumschaltung kann über die serielle Schnittstelle 5 des elektronischen Energiezählers erfolgen.
Weitere Anzeigeeinheiten 4 können in weiteren Ausführungsformen eingesetzt werden. Diese können z.B. die Prüf- und Kalibrierzeiten verkürzen und nur zu diesem Zweck verwendet werden. Dabei kann z.B. eine Lumineszenzdiode für den Kleinlastbereich zur Messung des Anlaufstromes, zur Messung oder Genauigkeitsmessung am unteren Messbereich sowie eine weitere zur Zählwerksprüfung eingesetzt werden.
Der mit der Steuer- und Verarbeitungseinrichtung 3 verbundene nichtflüchtige Speicher dient neben der Speicherung auch der Datensicherung. Dabei können unter anderem folgende weitere Daten gespeichert werden:
- die Gerätenummer einschließlich der Jahreszahl,
- der Zählerstand mehrerer Tarife,
- der aktuell geschaltete Tarif,
- den auf ein periodisches Intervall bezogenen Maximalwert, der über den elektronischen Energiezähler abgegebenen Leistung und
- die über einen beliebig gewählten Zeitraum abgegebene Leistung, die separat von der Tarifzählung gespeichert wird.
Im Falle eines Spannungausfalls müssen alle wichtigen Daten im nichtflüchtigen Speicher stehen, so dass diese nicht verloren gehen. Deshalb werden die zu sichernden Daten immer dann gespeichert, wenn eine Wertänderung erfolgt. Weiterhin wird die Spannung über einen kurzen Zeitraum gepuffert. Der Zeitraum reicht dabei aus, um die Werte, die sich möglicherweise gleichzeitig geändert haben, zu sichern.
In einer weiteren Ausführungsform kann die Steuer- und verarbeitungseinrichtung 3 der Tarifumschaltung, der Maximalwertbestimmung und/oder zeitbezogenen Energiemessung dienen. Die Umschaltung von einem zum anderen Tarif erfolgt softwaregesteuert über Befehle, die die Steuer- und Verarbeitungseinrichtung 3 über die serielle Schnittstelle 5 erhält. Ebenso wird die Maximalwertbestimmung der über ein periodisches Messintervall und die Ein-/Ausschaltung der zeitbezogenen Erfassung der über den elektronischen Energiezähler abgegebenen Energie über die serielle Schnittstelle 5 gesteuert. Auf Anforderung kann der elektronische Energiezähler die gespeicherten Zählerwerte über diese Schnittstelle 5 senden.
In einer weiteren Ausführungsform können auch weitere Schnittstellen durch die Steuer- und Verarbeitungseinrichtung 3 angesteuert werden, wie z.B. M-Bus, Z-Bus, RS 485, LON und/oder Powerline.
Die Stromversorgungseinheit 6 für den elektronischen Energiezähler wird in bekannterweise realisiert.
Die Messung des fließenden elektrischen Stromes erfolgt über einen niederohmigen Messwiderstand 1, der in den Leiter/die Phase L zum Verbraucher geschalten ist.

### 2. Ausführungsbeispiel

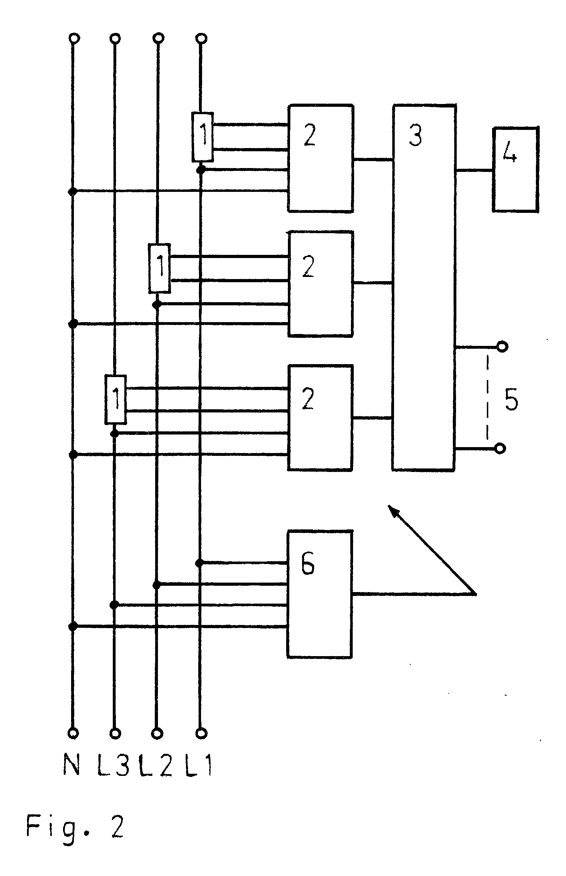

Eine Einrichtung als elektronischer Energiezähler für Dreiphasennetze besteht in einem zweiten Ausführungsbeispiel entsprechend der Darstellung in der Fig. 2 aus den Grundbestandteilen
- drei gleiche Anordnungen 2 zur Strom- und Spannungsmessung in dem jeweiligen Leiter/der jeweiligen Phase L1, L2, L3, Bildung des Produktes und des Integrals über die Messzeit und Erzeugung einer der übertragenden elektrischen Arbeit proportionalen Impulsfolge,
- einer Steuer- und Verarbeitungseinrichtung 3, insbesondere ein Mikrorechner, ein Mikrocontroller, eine programmierbare Logik jeweils mit Speichern,
- einer Anzeigeeinheit 4,
- mindestens einer Schnittstelle 5 und
- einer Stromversorgungseinheit 6.
Die drei gleichen Anordnungen 2 als Messsysteme, wobei jede Anordnung 2 ohne galvanische Trennung in dem jeweiligen Leiter/der jeweiligen Phase L1, L2, L3 die Strom- und Spannungsmessung ausführt, das Produkt bildet, das Integral über die Messzeit bildet und eine der übertragenden elektrischen Arbeit proportionalen Impulsfolge mit entsprechenden linearen später zu korrigierenden Messfehler bis zu ± 10% erzeugt. Diese drei gleichartigen Anordnungen 2 als Messwertverarbeitungen werden aus den jeweiligen Leiter/der jeweiligen Phase L1, L2, L3 durch die Stromversorgungseinheit 6 mit elektrischer Energie versorgt. Die Messwerte in Form einer Impulsfolge werden über einen Optokoppler galvanisch getrennt der Steuer- und Verarbeitungseinrichtung 3, die auf Bezugsbasis Nullleiter N arbeitet, jeweils an einem interruptfähigen Eingang zugeführt und in diesem System wie im ersten Ausführungsbeispiel dargestellt und beschrieben dreikanalig mit dem jeweiligem Korrekturfaktor korrigiert, summiert und für Anzeigeeinrichtungen 4, Zählwerke und Schnittstellen 5 entsprechend des ersten Ausführungsbeispiels aufbereitet. Damit ist für jedes der drei Messsysteme ein nichtverlustiger Speicher für die wichtigsten Betriebsdaten und Steueralgorithmen enthalten.
Die Messung des fließenden elektrischen Stromes zum Verbraucher erfolgt über niederohmige Messwiderstände 1. Diese befinden sich in den Leitern/Phasen L1, L2, L3 zum Verbraucher. Die Realisierung und der Aufbau der niederohmigen Messwiderstände 1 ist bekannt.

Die Stromversorgungseinheit 6 für diesen elektronischen Energiezähler in Dreiphasensystemen ist in bekannterweise entweder in einer ersten Ausführungsform mit einem Transformator oder mehreren Transformatoren versehen oder in einer zweiten Ausführungsform transformatorlos als C- Netzteil ausgeführt.

## Patentansprüche

1. Einrichtung zur Messung des fließenden elektrischen Stromes in mindestens einem elektrischen Leiter, der mit wenigstens einem elektrischen Verbraucher verbunden ist, mit folgenden Merkmalen:
- einem in den elektrischen Leiter (L) zum elektrischen Verbraucher geschaltetem niederohmigen Messwiderstand (1),
- einer mit dem niederohmigen Messwiderstand (1) verbundenen, den im elektrischen Leiter fließenden elektrischen Strom dadurch messenden und diese Messwerte in äquivalente elektrische Impulsfolgen wandelnden Anordnung (2),
- zum Ersten mit der Anordnung (2) verbundenen,
- zum Zweiten die elektrische Impulsfolge in Messintervallen zählenden, das Ergebnis des Messintervalls aus einer gegenüber einer elektrischen Impulsfolge einer Referenzeinrichtung bei der Kalibrierung der Anordnung (2) vergleichenden, damit den Messfehler als Anzahl von Impulsen der Anordnung (2) gegenüber der Referenzeinrichtung feststellbaren, diese Anzahl von Impulsen des Messfehlers im Messintervall zuordnenden und bei Abweichungen durch Unterdrückung oder Ergänzung der Impulsfolge im Messintervall korrigierenden,
zum Dritten die Messintervalle aufsummierenden und
zum Vierten diese Summe nach vorgegebenen Merkmalen zuordnenden Steuer- und Verarbeitungseinrichtung (3) und
- einer mit einer elektrischen Energiequelle, der Anordnung (2) und der Steuer- und Verarbeitungseinrichtung (3) zusammengeschalteten Stromversorgungseinheit (6).

2. Einrichtung nach Patentanspruch 1, **dadurch gekennzeichnet, dass** die Anordnung (2) mit dem mindestens einen elektrischen Leiter (L) und einem Bezugspotential (N) so zusammengeschaltet ist, dass das eine neben dem elektrischen Strom gleichzeitig die anliegende elektrische Spannung messende Anordnung (2) ist, dass das weiterhin eine die Messwerte des fließenden elektrischen Stromes und der dazu anliegenden elektrischen Spannungen in äquivalente elektrische Impulsfolgen der Leistung wandelnde Anordnung (2) ist und dass der niederohmige Messwiderstand (1), die Anordnung (2), die Steuer- und Verarbeitungseinrichtung (3) und die Stromversorgungseinheit (6) ein elektronischer Energiezähler ist.

3. Einrichtung nach Patentanspruch 1 oder den Patentansprüchen 1 un 2, **dadurch gekennzeichnet, dass** die Anordnung (2) mit einem zum Ersten in Messintervallen die elektrische Impulsfolge zählenden, einem entsprechend einem Messfehler wenigstens eines Messbereiches der Anordnung (2) vorgegebenen und/oder vorgebbaren Wert oder Energiewert der gezählten Impulsfolge je Messintervall zuordnenden und das Messintervall bei Abweichungen des vorgegebenen und/oder vorgebbaren Wertes oder Energiewertes entsprechend des Messbereiches im Messintervall korrigierenden, zum Zweiten die Messintervalle aufsummierenden und zum Dritten diese Summe nach vorgegebenen Merkmalen zuordnenden Steuer- und Verarbeitungseinrichtung (3) zusammengeschaltet ist.

4. Einrichtung nach Patentanspruch 1 oder den Patentansprüchen 1 und 2, **dadurch gekennzeichnet, dass** das eine die innerhalb von mindestens einem Messbereich zahlenmäßig vorbestimmte und bei der Inbetriebnahme in einer Speichereinheit der Verarbeitungseinheit fest installierte und nicht manipulierbare Impulszahl im Messintervall, wobei in jedem Messintervall gleichzeitig der fließende elektrische Strom und die dabei anliegende elektrische Spannung gemessen wird, innerhalb der Impulsfolge des Messintervalls einer aktuellen Messung, wobei ein Energiewert im Zeitbereich des Messintervalls zugeordnet wird, unterdrückende oder ergänzende Steuer- und Verarbeitungseinrichtung (3) ist.

5. Einrichtung nach Patentanspruch 4, **dadurch gekennzeichnet, dass** das Messintervall in n Unterintervalle aufgeteilt ist, dass die zu unterdrückenden oder zu ergänzenden Impulse in den n-1 Unterintervallen und dass der Rest der zu unterdrückenden oder zu ergänzenden Impulse insbesondere im letzten Unterintervall gleichverteilt sind.

6. Einrichtung nach Patentanspruch 2, **dadurch gekennzeichnet, dass** die Anordnung (2) aus einem mit dem elektrischen Leiter (L) und dem Nullleiter (N) verbundenen ersten Analog-Digital-Umsetzer, einem mit zwei Abgriffen eines in den elektrischen Leiter geschalteten niederohmigen Messwiderstandes verbundenen zweiten Analog-Digital-Umsetzers, einem den Analog-Digital-Umsetzern nachgeschalteten digitalen Multiplizierer und Leistungs-Frequenz-Wandler besteht.

7. Einrichtung nach Patentanspruch 1, **dadurch gekennzeichnet, dass** bei mehreren elektrischen Leitern (L1, L2, L3) zu wenigstens einem Verbraucher jeweils ein niederohmiger Messwiderstand (1) in einen elektrischen Leiter (L1, L2, L3) geschalten ist, dass jeweils ein niederohmiger Messwiderstand (1) mit einer Anordnung (2) verbunden ist und dass die Anordnungen (2) mit einer Steuer- und Verarbeitungseinrichtung (3) zusammengeschaltet sind.

8. Verfahren zur Fehlerkorrektur von Einrichtungen zur Messung des fließenden elektrischen Stromes in mindestens einem elektrischen Leiter, der mit wenigstens einem elektrischen Verbraucher verbunden ist, und wobei die Messwerte in eine dem Messwert äquivalente elektrische Impulsfolge gewandelt werden mit folgenden Schritten
- Zählung der elektrischen Impulsfolge und Feststellung des Messfehlers der Einrichtung innerhalb mindestens eines Messintervalls gegenüber einer Referenzeinrichtung in wenigstens einem Messbereich,
- Speicherung des Messfehlers als Differenz der Impulsfolge des Messwerts der Einrichtung gegenüber der Impulsfolge des Vergleichswerts der Referenzeinrichtung innerhalb eines Messintervalls als Anzahl von Impulsen,
- Speicherung der Anzahl der Impulse der Differenz im Messintervall in einem Speicher und
- Unterdrückung oder Ergänzung der Impulse der Differenz bei aktuellen Messwerten innerhalb des Zeitbereichs im Messintervall bei Betrieb der Einrichtung im Messbereich.

9. Verfahren nach Patentanspruch 8, **dadurch gekennzeichnet, dass** in einer Anordnung (2) über einen niederohmigen Messwiderstand (1) in wenigstens einen elektrischen Leiter (L) der fließende elektrische Strom zu einem elektrischen Verbraucher und die gegenüber einem Bezugspotential (N) anliegende elektrische Spannung gemessen und die Messwerte des fließenden elektrischen Stromes und der dazu anliegenden elektrischen Spannung in äquivalente elektrische Impulsfolgen der Leistung gewandelt werden, dass die elektrischen Impulsfolgen gezählt, einem Energiewert im Zeitbereich des Messintervalls zugeordnet und der Messfehler im Zeitbereich des Messintervalls der Einrichtung gegenüber einer Referenzeinrichtung in wenigstens einem Messbereich ermittelt wird, dass der Messfehler als Differenz der Impulsfolge des Messwerts der Einrichtung gegenüber der Impulsfolge des Vergleichswerts innerhalb eines Messintervalls als Anzahl von Impulsen und die Anzahl der Impulse der Differenz im Messintervall gespeichert werden und dass die Impulse der Differenz bei aktuellen Messwerten innerhalb des Messintervalls bei Betrieb unterdrückt oder ergänzt werden.

10. Verfahren nach einem der Patentansprüche 8 oder 9, **dadurch gekennzeichnet, dass** das Messintervall in n Unterintervalle aufgeteilt wird, dass die zu unterdrückenden oder zu ergänzenden Impulse in den n-1 Unterintervallen gleichverteilt sind und dass der Rest der zu unterdrückenden oder zu ergänzenden Impulse insbesondere im letzten Unterintervall erfolgt.
